# FASCICULE DE BREVET EUROPEEN

(11) **EP 0 669 576 B1**
(45) Date de publication et mention de la délivrance du brevet: **19.06.1996**
(21) Numéro de dépôt: 95400420.6
(22) Date de dépôt: 27.02.1995
(51) Int. Cl.: G06F 11/20, G11C 29/00

(54) **Circuit de redondance de mémoire**
Speicherredundanzschaltung
Memory redundancy circuit

(30) Priorité: 28.02.1994 FR 9402282
(43) Date de publication de la demande: 30.08.1995
(73) Titulaire: SGS-THOMSON MICROELECTRONICS S.A., F-94250 Gentilly (FR)
(72) Inventeur: Devin, Jean, Cabinet Ballot-Schmit, F-94230 Cachan (FR)
(74) Mandataire: Schmit, Christian Norbert Marie

(56) Documents cités:
- EP-A- 0 410 413

## Description

L'invention concerne un circuit de redondance de mémoire applicable notamment aux mémoires réalisées en circuits intégrés.

Il est connu dans la technique d'adressage des mémoires de pouvoir substituer à une partie d'une mémoire principale, lorsqu'elle s'avère défectueuse, une mémoire de secours ou mémoire de redondance.

De façon classique, une mémoire principale est organisée en lignes et colonnes. Pour pallier des défauts détectés sur des lignes ou des colonnes, on prévoit des lignes ou respectivement des colonnes de redondance.

Par exemple, si une colonne de la mémoire principale est défectueuse, on la remplace par une colonne de redondance de la manière suivante: l'adresse de la colonne défectueuse est mise en mémoire dans une mémoire d'adresse défectueuse ; cette mémoire d'adresse défectueuse est une mémoire de type adressable par son contenu appelée ci-après mémoire CAM (Content Adressable Memory) ; chaque fois qu'une adresse est appliquée à la mémoire principale, cette adresse est également appliquée à la mémoire CAM. Si l'adresse appliquée est identique à l'adresse mémorisée, un circuit de redondance est mis en service et agit pour déconnecter la colonne défectueuse et connecter à sa place une colonne de redondance, d'une manière invisible pour l'utilisateur.

En pratique, selon l'organisation de la mémoire principale, si une colonne est défectueuse, on remplacera plutôt un groupe de colonnes contenant cette colonne défectueuse par un groupe de colonnes de redondance : en général, si un groupe de colonnes est défini par un bit d'adresse de la mémoire de grande capacité, c'est ce groupe de colonnes qu'on remplacera dans son ensemble. Dans la suite, pour simplifier, on se contentera de parler du remplacement d'une colonne plutôt que du remplacement d'un groupe de colonnes. La même chose est évidement possible pour les lignes.

Pour une mémoire principale de plusieurs mégabits, on prévoit la possibilité de réparer plusieurs défauts; il y a donc autant de colonnes ou de lignes de redondance que de colonnes ou de lignes en défaut qu'on veut pouvoir réparer. A chaque colonne de redondance est associée une mémoire CAM respective qui contient l'adresse d'une colonne défectueuse. Si on veut réparer N défauts, il faut N colonnes de redondance et N mémoires CAM. Typiquement N=36 pour une mémoire de 4 ou 16 mégabits.

Si une colonne de la mémoire principale est désignée par une adresse de M bits (par exemple M=5), chaque mémoire CAM contient au moins M+1 bit : M bits pour définir l'adresse d'une colonne défectueuse et un bit de validation pour indiquer que le circuit de redondance correspondant à cette mémoire CAM doit effectivement être activé lorsque l'adresse défectueuse est appliquée à la mémoire CAM.

Lors du test d'une mémoire principale et de la détection de défauts, on doit donc enregistrer convenablement des mémoires CAM pour que lors de tentatives d'utilisations ultérieures des parties défectueuses de la mémoire principale, ces mémoires CAM substituent automatiquement la mémoire de redondance aux parties défectueuses de la mémoire principale.

Cependant, dans certains systèmes, les mémoires CAM sont constituées d'éléments mémoires qui comportent des cellules mémoires complémentaires. Selon que l'on enregistre un un ou un zéro dans un tel élément, une des cellules mémoires de l'élément doit être programmée, ou l'autre. De ce fait tous les éléments doivent être programmés, qu'ils soient utilisés ou non. Car en absence de programmation, ces mémoires CAM risquent néanmoins de fournir à tort une information (information d'adresse défectueuse). Différents moyens peuvent être envisagés pour permettre de savoir si une mémoire CAM doit être utilisée ou non.

On peut, par exemple, prévoir un bit de validation associé à chaque mémoire CAM pour indiquer si cette mémoire CAM est utilisée ou non. Cependant, cela nécessite, lors de test, de positionner ces moyens, en l'occurrence le bit de validation de chaque mémoire CAM, dans la position qui correspond à l'utilisation ou la non utilisation de chaque mémoire CAM. Cela nécessite donc quand même un temps de test supplémentaire au moment de l'initialisation de ces mémoires CAM. Le but de l'invention est d'éviter, dans certains cas, les opérations d'initialisation des mémoires CAM et par suite, réduire ce temps d'initialisation. Notamment, dans le cas où aucun défaut n'est décelé dans une mémoire principale, aucune mémoire CAM ne doit être utilisée et on peut traiter globalement l'ensemble des mémoires CAM relatives à cette mémoire principale. Dans ce but, dans l'invention ou ajoute un élément mémoire supplémentaire qui, par son état, dit, s'il faut ou non considérer l'état des mémoires CAM. On montre qu'on gagne ainsi en moyenne 3 secondes pour le test de chaque mémoire: c'est très significatif.

L'invention concerne donc un circuit de redondance de mémoire pour mémoire principale comportant plusieurs zones mémoires accessibles chacune par une adresse mémoire, ce circuit de redondance comprenant une mémoire de redondance adressable par une mémoire d'adresses défectueuses de type adressable par son contenu, destinée à contenir différentes adresses défectueuses correspondant à des zones défectueuses de la mémoire principale et qui, à chaque adressage de la mémoire principale, compare l'adresse mémoire principale à chaque adresse défectueuse pour, en cas de concordance, interdire l'adressage de la mémoire principale et adresser une zone de la mémoire de redondance, caractérisé en ce qu'il comporte un circuit d'inhibition possédant au moins un premier état dans lequel il fournit un signal d'inhibition à la mémoire d'adresses défectueuses pour interdire ou rendre inefficace son fonctionnement, de sorte que l'adressage de la mémoire principale s'effectue normalement lorsque cette dernière ne présente aucun défaut.

L'invention concerne également un procédé d'utilisation d'une mémoire principale applicable au circuit selon l'une quelconque des revendications de dispositif, caractérisé en ce qu'il prévoit après le test de la mémoire principale de mettre le circuit d'inhibition (IN) dans une situation telle que, si la mémoire ne présente aucun défaut, il inhibe ou il rende inefficace le fonctionnement de la mémoire d'adresse défectueuse.

Pour réaliser les mémoires CAM, on a d'abord utilisé des groupes de fusibles physiques, grillés électriquement ou grillés par un faisceau laser, chaque fusible représentant un bit d'adresse ou un bit de validation. Ces fusibles présentaient des inconvénients (fiabilité, encombrement, consommation, difficulté de programmation) et ont été rapidement remplacés par des cellules de mémoire non volatile non effaçables. Ces dernières présentaient également des inconvénients (consommation de courant importante), et on s'est orienté progressivement vers l'utilisation de bascules bistables programmables comprenant deux transistors à grille flottante pour chaque bit d'adresse ou de validation.

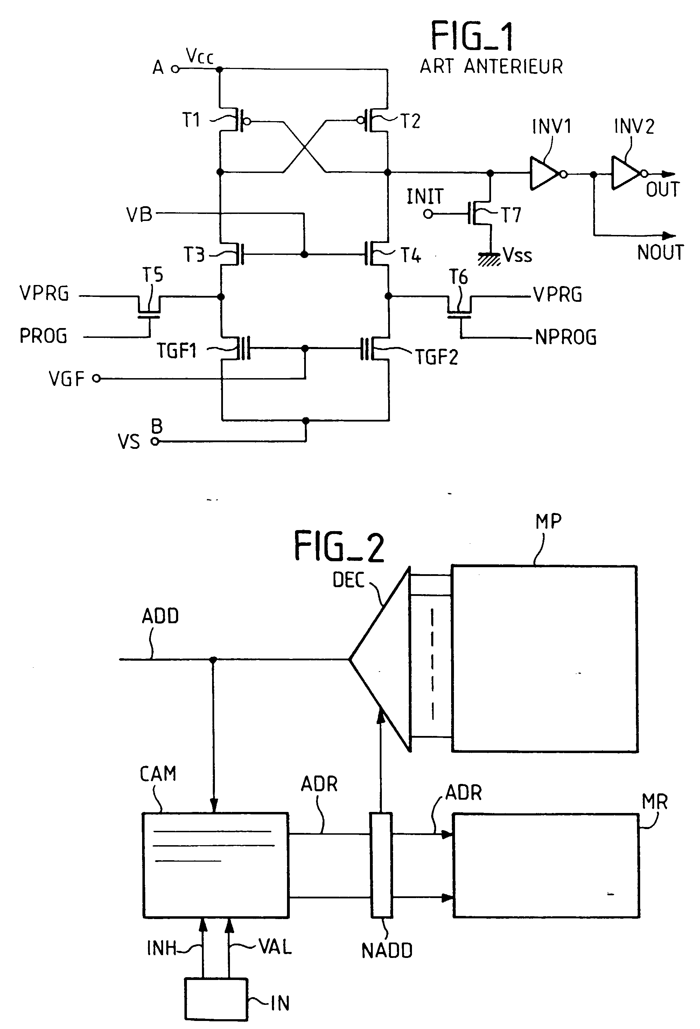

La figure 1 représente une bascule bistable programmable non volatile de la technique antérieure, constituant une cellule de mémorisation d'un bit d'adresse défectueuse (ou d'un bit de validation), et constituant donc une des M+1 cellules d'une mémoire CAM d'adresse défectueuse.

La sortie OUT de cette cellule est à un niveau logique 0 ou à 1 selon l'état dans lequel la bascule est programmée. Cette sortie définit donc la valeur d'un bit d'adresse (ou la valeur du bit de validation).

Si la cellule correspond à un des M bits d'adresse défectueuse, la sortie de chaque cellule de ces M bits d'adresse est appliquée à une entrée de porte OU-Exclusif (non représentée). La porte OU-Exclusif reçoit sur une autre entrée un bit d'adresse correspondant, reçu par la mémoire principale; les sorties des portes OU-Exclusif correspondant aux différents bits d'adresse d'une même mémoire défectueuse sont appliquées à une entrée d'une porte NOR (non représentée) ; la sortie de cette dernière fournit un niveau logique 1 uniquement s'il y a coïncidence entre tous les bits d'adresse appliqués et tous les bits correspondants de la mémoire défectueuse. La sortie de la porte NOR est validée par la sortie de la cellule de mémoire correspondant au bit de validation, par exemple grâce à une porte ET (non représentée). La sortie de la porte ET est la sortie de la mémoire CAM et sert à mettre en service un chemin de redondance chaque fois que l'adresse appliquée à la mémoire principale correspond à l'adresse défectueuse enregistrée.

Dans le cas général, il y a N mémoires d'adresse défectueuse, par exemple N=36. Lors du test de la mémoire principale, la détection d'une colonne défectueuse déclenche le stockage de l'adresse de cette colonne dans une des mémoires CAM. Les différentes mémoires CAM sont ainsi successivement programmées au fur et à mesure de la détection des défauts. En fonctionnement normal de la mémoire principale, les adresses de celle-ci sont appliquées simultanément à toutes les mémoires CAM. S'il y a correspondance de l'adresse appliquée et de l'adresse stockée dans l'une d'elles, le chemin de redondance correspondant à celle-ci est activé.

Pour permettre la programmation d'une adresse défectueuse dans une mémoire CAM, on prévoit donc qu'un bit d'adresse respectif de la mémoire principale est appliqué à chaque cellule de la mémoire CAM. La programmation est effectuée sur ordre de l'appareil de test en cas de détection d'un défaut à l'adresse en cours de test.

La cellule de mémoire individuelle représentée à la figure 1 comporte deux branches avec un transistor à grille flottante TGF1, TGF2 dans chaque branche ; les branches sont agencées de manière à former une bascule bistable dès qu'un de ces deux transistors est programmé ; l'état de la bascule, représenté par la sortie OUT et correspondant à un bit d'adresse ou un bit de validation, est alors fonction de celui des deux transistors qui est programmé. Au départ les deux transistors sont dans un état non-programmé, ou état vierge. Lors du test de la mémoire, on programme l'un des deux transistors pour obtenir soit un 0 soit un 1 en sortie OUT de la cellule, définissant ainsi un état stable définitif 0 ou 1 de la cellule.

Plus précisément, la cellule de la figure 1 comprend deux branches identiques en parallèle entre une borne d'alimentation A (potentiel Vcc de l'ordre de 3 volts) et une borne B ; la borne B est à un potentiel VS nul en mode de lecture ou de programmation et peut aussi être portée à un potentiel VS élevé (12 volts) en mode d'effacement si un mode d'effacement est prévu (flash EPROM) ; en série dans chaque branche, on trouve un transistor à canal P (T1, T2), un transistor à canal N (T3, T4), et un transistor à grille flottante (TGF1, TGF2). La grille du transistor à canal P (T1, T2) de l'une des branches est reliée au drain du transistor à canal P (T2, T1) de l'autre branche. Les grilles des transistors à canal N (T3, T4) sont reliées ensemble à un potentiel commun VB dont la valeur dépend du mode de fonctionnement (environ 1,8 volt en lecture ; zéro volt en programmation ou effacement pour avoir 1 volt sur le drain des cellules en lecture). Les transistors T3 et T4 sont des transistors d'isolation pour empêcher la transmission aux transistors T1 et T2 des tensions relativement élevées appliquées aux transistors à grille flottante en mode de programmation ou effacement. Les grilles des transistors à grille flottante TGF1, TGF2, sont reliées à un potentiel commun VGF dépendant du fonctionnement (3 volts environ en lecture, 12 volts environ en programmation). La source de ces transistors est reliée au noeud B (potentiel VS). Les potentiels de drain des transistors à grille flottante sont contrôlés par des transistors T5 et T6 respectivement, permettant soit de relier le drain à un potentiel de programmation VPRG (transistor T5 ou T6 conducteur) soit de laisser le drain en haute impédance (transistor T5 ou T6 bloqué). En mode de programmation, la grille du transistor T5 est contrôlée par un signal de programmation PROG et la grille de T6 par un signal complémentaire NPROG. De la sorte on choisit selon l'état du signal PROG celui des deux transistors à grille flottante qui doit être programmé et celui qui doit rester vierge. En mode de lecture, le drain des transistors T5 et T6 reste en haute impédance, la tension VPRG n'étant pas appliquée à ces drains.

La cellule est appelée "bistable" car elle possède un état stable parmi deux possibles, l'état stable qu'elle prend dépendant de celui des deux transistors qui a été programmé. L'état de la cellule est lu sur le drain d'un des transistors à canal P (T2 par exemple). Ce drain est relié à l'entrée d'un premier inverseur INV1 suivi d'un deuxième inverseur INV2. La sortie de INV2 est la sortie OUT de la cellule. La sortie INV1 sert de sortie complémentaire NOUT si on en a besoin. Enfin, un transistor supplémentaire T7 peut permettre, uniquement en mode de test, pour éviter les noeuds flottants quand T3 et T4 sont bloqués, de mettre à la masse temporairement (pour une initialisation de l'état de la cellule à chaque remise sous tension) l'entrée de l'inverseur INV1 ; la grille de ce transistor est commandée par un créneau d'initialisation INIT produit par un circuit classique de remise sous tension ("Power On Reset") non représenté.

L'invention est applicable à un système comportant des mémoires CAM du type de celle représentée en figure 1.

L'invention est donc également applicable à un circuit de redondance dans lequel la mémoire d'adresse défectueuse comporte deux transistors à grille flottante, du type qui constitue une bascule bistable dont l'état est défini par programmation d'un des transistors et est indiqué par l'état d'une sortie connectée au drain (ou à la source) d'un des transistors. Cette sortie est connectée à un circuit de comparaison qui reçoit par ailleurs un élément d'information d'adresse de mémoire principale et fournit un signal d'identité en cas d'égalité de l'élément d'adresse de mémoire principale et du contenu de la mémoire d'adresse défectueuse. Un circuit à coïncidence a ses entrées connectées à plusieurs sorties de circuits de comparaison pour fournir un signal en cas d'identité d'adresses mémoires. De plus, ce circuit à coïncidence possède une entrée supplémentaire pour recevoir un signal de validation ou l'inverse d'un signal d'inhibition.

Les différents objets et caractéristiques de l'invention apparaîtront plus clairement dans la description qui va suivre et dans les figures annexées qui représentent :
- la figure 1, une cellule d'adressage mémoire décrite précédemment ;
- la figure 2, un diagramme général du circuit selon l'invention ;
- les figures 3 à 5, un exemple de réalisation dans lequel le circuit de l'invention intervient sur le fonctionnement du circuit de comparaison d'une adresse mémoire principale et d'une adresse mémoire défectueuse ;
- la figure 6, une application de l'invention au circuit mémoire de la figure 1 ;
- la figure 7, une variante de réalisation de l'invention appliquée à titre d'exemple au circuit de la figure 1.

En se rapportant à la figure 2, on va tout d'abord décrire un exemple de réalisation simplifié du dispositif selon l'invention.

Une mémoire principale MP comporte un grand nombre de zones mémoires non détaillées sur la figure. Ces zones peuvent être de façon classique arrangées en lignes et colonnes. Chaque zone est sélectionnée (ou adressée) à l'aide d'un dispositif d'adressage DEC (ou décodeur d'adresse). Le dispositif d'adressage DEC reçoit une adresse ADD et permet d'accéder à une zone particulière de la mémoire principale MP. Une ou plusieurs zones pouvant être trouvées défectueuses, elles doivent être remplacées par des zones de secours qui se trouvent dans ce qu'on appelle une mémoire de redondance MR.

Les zones de la mémoire principale MP qui sont détectées en défaut ont leur adresse, qu'on appellera pour simplifier adresse défectueuse, mémorisée dans une mémoire telle qu'une mémoire CAM décrite précédemment.

Selon l'invention, si la totalité de la mémoire principale MP, par exemple, est exempt de défaut, la mémoire CAM ne doit pas servir. Pour cela, un circuit d'inhibition IN est mis dans une situation telle qu'il rend inopérant le fonctionnement de la mémoire CAM en transmettant à celle-ci un signal INH. Si ce signal n'est pas transmis, cela veut dire que la mémoire CAM peut être utilisée. Par exemple, un signal de validation VAL est fourni par le circuit IN. Lorsqu'une adresse ADD est alors transmise au décodeur DEC, elle est également transmise à la mémoire CAM qui compare l'adresse ADD à toutes les adresses défectueuses qu'elle a en mémoire. En cas de concordance, la mémoire CAM délivre un signal ADR pour empêcher l'adressage de la zone mémoire d'adresse ADD dans la mémoire principale et pour adresser à la place une zone de la mémoire de redondance MR. Cela peut se faire par tout moyen compatible avec les moyens d'adressage de la mémoire principale MP. Sur la figure 2, de façon simplifiée un circuit NADD fournit, en cas d'une telle concordance, un signal au décodeur DEC pour lui interdire d'adresser la mémoire MP.

A l'inverse, si le signal d'inhibition INH est fourni par le circuit IN à la place du signal de validation VAL, la comparaison d'adresses (adresse mémoire principale et adresses défectueuses) ne peut pas se faire ou est rendue inefficace et l'adressage de la mémoire MP peut se faire normalement.

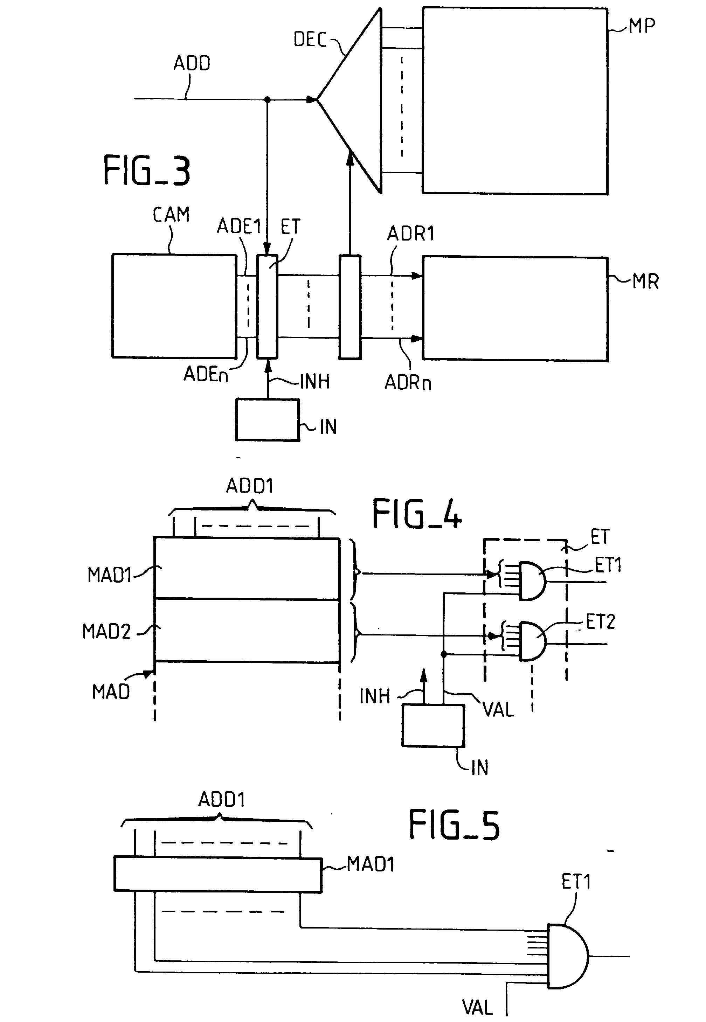

La figure 3 représente une forme de réalisation du dispositif de la figure 2. La mémoire d'adresses défectueuses MAD proprement dite a été représentée séparée d'un circuit à coïncidence ET permettant de s'assurer que les différents bits d'adresses ADD sont identiques aux bits d'adresses contenues dans la mémoire MAD. A chaque réception d'une adresse ADD, cette adresse est comparée aux différentes adresses ADE1 à ADEn contenues dans la mémoire MAD en faisant des OU-Exclusif sur les différents bits d'adresses. En cas d'identité dans une comparaison, le circuit ET fournit un signal ADR1 à ADRn pour, d'une part, interdire l'adressage de la mémoire MP à l'adresse ADD et pour d'autre part, adresser une zone de la mémoire de redondance MR. Ce fonctionnement est possible en l'absence du signal d'inhibition INH ou si un signal de validation VAL (voir précédemment) non représenté sur la figure 3 est fourni au circuit ET.

Par contre si le circuit d'inhibition IN fournit un signal d'inhibition (ou ne fournit pas le signal de validation VAL précédent), le circuit ET ne peut pas fournir de signal d'adresse ADR1 à ADRm et l'adressage de la mémoire principale s'effectue normalement. Comme cela est représenté en figure 4, le circuit à coïncidence comporte un circuit à coïncidence ET1, ET2, par adresse défectueuse fournie par la mémoire MAD. Selon le mode de représentation de la figure 4, ce n'est pas le signal INH qui est fourni à une entrée de chaque circuit ET1, ET2, mais c'est un signal inverse VAL permettant le fonctionnement en coïncidence de type ET des circuits ET1, ET2.

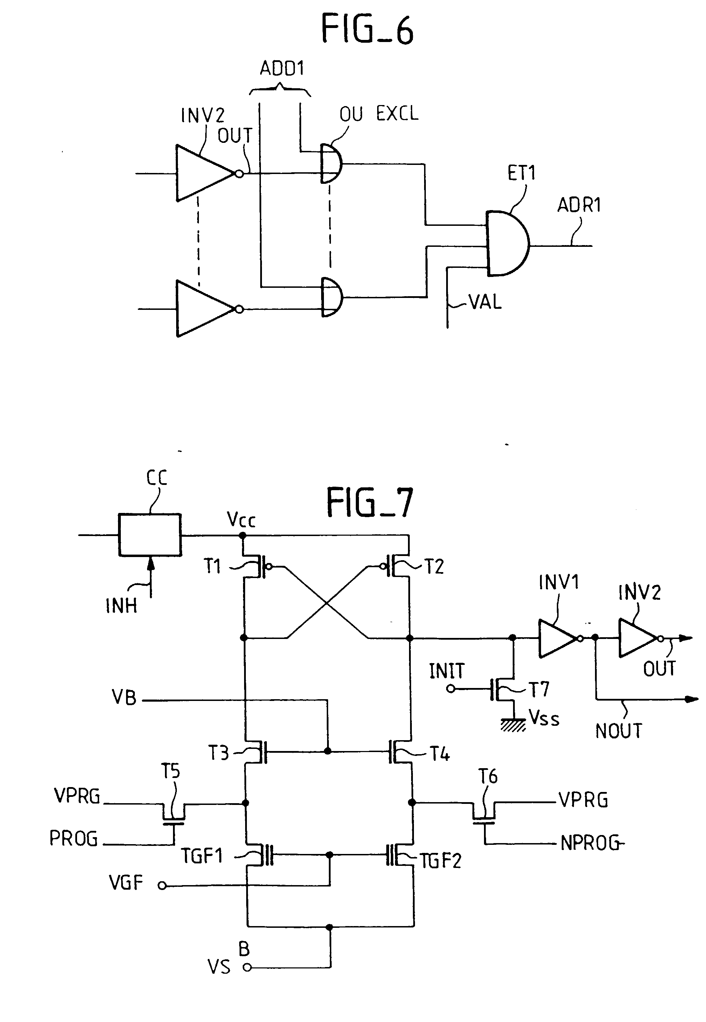

Plus précisément, la figure 5 montre qu'une mémoire d'adresse défectueuse MAD1 reçoit une adresse ADD1. Cette mémoire MAD1 compare bit à bit l'adresse ADD1 et l'adresse défectueuse contenue dans la mémoire MAD1. Cette comparaison se fait à l'aide d'une logique de OU-Exclusif par exemple. La sortie de chaque circuit de comparaison est connectée à une entrée d'un circuit à coïncidence, le circuit ET1 dans l'exemple. Si les deux adresses comparées sont identiques, les entrées du circuit sont à un niveau logique 1 et le circuit ET1 fournit un signal de commande ADR1.

De plus, selon l'invention, une entrée supplémentaire du circuit à coïncidence ET1 reçoit un signal de validation permettant au circuit ET1 de fournir le signal ADR1. En l'absence de signal de validation VAL, comme cela est prévu dans l'invention, le circuit ET1 est inhibé et ne fournit pas de signal de commande ADR1.

L'invention est applicable à un mode de réalisation d'une mémoire CAM telle que celle représentée en figure 1 et décrite précédemment. Dans ce cas, selon la figure 6, une mémoire CAM 35 correspondant à la mémoire MAD1 et au circuit ET1 de la figure 5, comporte comme circuit de sortie, les inverseurs INV2 des différents bits d'adresse de la mémoire MAD1. Une porte OU-Exclusif comparant deux à deux les bits d'adresses de mémoire principale ADD1 et de mémoire d'adresse défectueuse. Enfin un circuit à coïncidence ET1 a ses entrées connectées aux sorties des portes OU-Exclusif d'une même mémoire MAD1. Une entrée supplémentaire du circuit ET1 reçoit le signal de validation VAL.

Dans les exemples de réalisation des figures 4 à 6, on a prévu que le circuit IN fournit un signal de validation VAL qui valide le fonctionnement du circuit à coïncidence ET. Cependant, sans sortir du cadre de l'invention et en prévoyant un autre type de logique, on pourrait utiliser le signal d'inhibition INH pour inhiber le fonctionnement du circuit ET, ou bien utiliser l'absence du signal INH pour autoriser le fonctionnement du circuit ET.

Selon une variante de réalisation, on prévoit également d'inhiber le fonctionnement de la mémoire CAM en coupant son alimentation électrique. C'est ainsi que sur la figure 7 on a prévu un circuit de coupure d'alimentation CC situé sur le fil d'alimentation du potentiel Vcc. Le circuit CC est commandé par le signal INH et interrompt la fourniture du potentiel Vcc lorsqu'on décide de mettre hors circuit la mémoire CAM. Egalement selon l'invention, le circuit d'inhibition est du même type que celui des circuits de la mémoire CAM. Par exemple, il est réalisé comme le circuit de la figure 1 avec des transistors à grilles flottantes. Le signal OUT de la figure 1 représente alors, par exemple, le signal d'inhibition INH et le signal NOUT représente le signal de validation VAL.

Le procédé de l'invention consiste donc à tester la mémoire principale (MP). Si aucun défaut n'est détecté, on met le circuit d'inhibition IN dans une situation telle qu'il émet le signal d'inhibition INH et n'émet plus le signal de validation VAL.

L'application du signal d'inhibition INH, ou l'inverse du signal VAL met hors service le circuit d'adressage de la mémoire de redondance. Cette mise hors service résulte soit de l'inhibition du fonctionnement du circuit CAM soit de son interdiction de fonctionnement.

## Revendications

1. Un circuit de redondance de mémoire pour mémoire principale (MP) portant plusieurs zones mémoires accessibles chacune par une adresse mémoire, ce circuit de redondance comprenant une mémoire de redondance adressable par une mémoire d'adresses défectueuses de type adressable par son contenu (CAM), destinée à contenir différentes adresses défectueuses correspondant à des zones défectueuses de la mémoire principale et qui, à chaque adressage de la mémoire principale, compare l'adresse mémoire principale à chaque adresse défectueuse pour, en cas de concordance, interdire l'adressage de la mémoire principale et adresser une zone de la mémoire de redondance, caractérisé en ce qu'il comporte un circuit d'inhibition (IN) possédant au moins un premier état dans lequel il fournit un signal d'inhibition (INH) à la mémoire d'adresses défectueuses (CAM) pour interdire ou rendre inefficace son fonctionnement, de sorte que l'adressage de la mémoire principale s'effectue normalement lorsque cette dernière ne présente aucun défaut.

2. Circuit selon la revendication 1, caractérisé en ce que le circuit d'inhibition (IN) comporte un deuxième état possible dans lequel il autorise ou il valide le fonctionnement de la mémoire d'adresses défectueuses (CAM).

3. Circuit selon la revendication 1, caractérisé en ce que le circuit d'inhibition (IN) est un circuit bistable.

4. Circuit selon la revendication 1, caractérisé en ce que la mémoire d'adresses défectueuses comporte un circuit à coïncidence (ET) recevant au moins un signal de comparaison d'une adresse mémoire principale et d'une adresse mémoire défectueuse, le circuit d'inhibition (IN) inhibant ou validant, selon son état, le fonctionnement du circuit à coïncidence (ET).

5. Circuit selon la revendication 5, caractérisé en ce que le circuit à coïncidence (ET) comporte un circuit logique (ET1.1, ET1.m) réalisant une fonction logique de type ET par adresse et possédant au moins une entrée par bit de comparaison d'un élément d'information d'adresse défectueuse (ADE1) avec un élément d'information d'adresse de mémoire principale (ADR) et une entrée supplémentaire pour un signal de validation (VAL) ou l'inverse du signal d'inhibition.

6. Circuit selon la revendication 5, caractérisé en ce qu'il comporte un circuit à coïncidence (ET) par adresse défectueuse (ADR1, ADRn).

7. Circuit selon la revendication 1, caractérisé en ce que la mémoire d'adresse défectueuse comporte au moins un circuit possédant deux transistors à grille flottante (TGF1, TGF2), du type qui constitue une bascule bistable dont l'état est défini par programmation d'un des transistors et est indiqué par l'état d'une sortie connectée au drain (ou à la source) d'un des transistors, cette sortie étant connectée à un circuit de comparaison (OU-EXCL) recevant par ailleurs un élément d'information d'adresse de mémoire principale (ADD1) et fournissant un signal de comparaison ; un circuit à coïncidence (ET) ayant ses entrées connectées à plusieurs sorties de circuits de comparaison (OU-EXCL) pour fournir un signal en cas d'identité d'une adresse de mémoire principale (ADD1) avec une adresse défectueuse, ce circuit de coïncidence possédant en outre une entrée supplémentaire pour recevoir l'inverse du signal d'inhibition (INH).

8. Circuit selon la revendication 1, caractérisé en ce que le circuit d'inhibition agit sur le circuit d'alimentation électrique (Vcc) de la mémoire d'adresse défectueuse (CAM) pour interdire son fonctionnement.

9. Circuit selon la revendication 3, caractérisé en ce que le circuit d'inhibition comporte deux transistors à grille flottante du type qui constitue une bascule bistable dont l'état est défini par programmation d'un des transistors et est indiqué par l'état d'une sortie connectée au drain (ou à la source) d'un des transistors et fournissant sur cette sortie le signal d'inhibition (INH) ou son inverse.

10. Procédé d'utilisation d'une mémoire principale applicable au circuit selon l'une quelconque des revendications 1 à 9, caractérisé en ce qu'il prévoit après le test de la mémoire principale de mettre le circuit d'inhibition (IN) dans une situation telle que, si la mémoire ne présente aucun défaut, il inhibe ou il rende inefficace le fonctionnement de la mémoire d'adresse défectueuse.

## Patentansprüche

1. Speicherredundanzschaltung für einen Hauptspeicher (MP) mit mehreren, jeweils mittels einer Speicheradresse zugänglichen Speicherbereichen, wobei die Speicherredundanzschaltung einen Redundanzspeicher umfaßt, der mittels eines Fehleradressenspeichers des durch seinen Inhalt adressierbaren Typs (CAM) adressierbar ist, welcher dazu vorgesehen ist, verschiedene, Fehlerbereichen des Hauptspeichers entsprechende Fehleradressen zu enthalten und welcher bei jeder Adressierung des Hauptspeichers die Hauptspeicheradresse mit jeder Fehleradresse vergleicht, um im Übereinstimmungsfall die Adressierung des Hauptspeichers zu untersagen und einen Bereich des Redundanzspeichers zu adressieren, dadurch gekennzeichnet, daß sie eine Sperrschaltung (IN) umfaßt mit zumindest einem ersten Zustand, in welchem sie dem Fehleradressenspeicher (CAM) ein Sperrsignal (INH) zuführt, um dessen Funktion zu unterbinden oder wirkungslos zu machen derart, daß die Adressierung des Hauptspeichers auf normale Weise erfolgt, wenn dieser letztgenannte keinerlei Fehler zeigt.

2. Schaltung nach Anspruch 1, dadurch gekennzeichnet, daß die Sperrschaltung (IN) einen zweiten möglichen Zustand umfaßt, in welchem sie die Funktion des Fehleradressenspeichers bestätigt oder freigibt.

3. Schaltung nach Anspruch 1, dadurch gekennzeichnet, daß die Sperrschaltung (IN) eine bistabile Schaltung ist.

4. Schaltung nach Anspruch 1, dadurch gekennzeichnet, daß der Fehleradressenspeicher eine Koinzidenzschaltung (ET) umfaßt, die zumindest ein Vergleichssignal einer Hauptspeicheradresse und einer Fehlerspeicheradresse empfängt, wobei die Sperrschaltung (IN) entsprechend ihres Zustands die Funktion der Koinzidenzschaltung (ET) sperrt oder freigibt.

5. Schaltung nach Anspruch 4, dadurch gekennzeichnet, daß die Koinzidenzschaltung (ET) eine logische Schaltung (ET1.1, ET1.m) umfaßt, welche eine logische UND-Funktion pro Adresse realisiert und welche zumindest einen Eingang pro Bit eines Vergleichs eines Fehleradressen-Informationselements (ADE1) mit einem Hauptspeicheradressen-Informationselement (ADR) sowie einen zusätzlichen Eingang für ein Freigabesignal (VAL) oder das Inverse des Sperrsignals aufweist.

6. Schaltung nach Anspruch 5, dadurch gekennzeichnet, daß sie eine Koinzidenzschaltung (ET) pro Fehleradresse (ADR1, ADRn) umfaßt.

7. Schaltung nach Anspruch 1, dadurch gekennzeichnet, daß der Fehleradressenspeicher zumindest eine Schaltung umfaßt, welche zwei Transistoren mit schwebendem Gate (TGF1, TGF2) aufiveist, die nach Art eines bistabilen Kippglieds aufgebaut sind, dessen Zustand durch Programmierung eines der Transistoren festgelegt und durch den Zustand eines mit dem Drain-Anschluß (oder dem Source-Anschluß) eines der Transistoren verbundenen Ausgangs angezeigt wird, wobei dieser Ausgang mit einer Vergleichsschaltung (EXKLUSIV-ODER) verbunden ist, die darüber hinaus ein Hauptspeicheradressen-Informationselement (ADD1) empfängt und ein Vergleichssignal abgibt; und daß eine Koinzidenzschaltung (ET) mit ihren Eingängen mit mehreren Ausgängen von Vergleichsschaltungen (EXKLUSIV-ODER) verbunden ist, um im Falle einer Identität einer Hauptspeicheradresse (ADD1) mit einer Fehleradresse ein Signal abzugeben, wobei die Koinzidenzschaltung ferner einen zusätzlichen Eingang zum Empfangen des Inversen des Sperrsignals (INH) aufweist.

8. Schaltung nach Anspruch 1, dadurch gekennzeichnet, daß die Sperrschaltung auf die Spannungsversorgungsschaltung (Vcc) des Fehleradressenspeichers (CAM) einwirkt, um dessen Funktion zu unterbinden.

9. Schaltung nach Anspruch 3, dadurch gekennzeichnet, daß die Sperrschaltung zwei Transistoren mit schwebendem Gate aufweist, die nach Art eines bistabilen Kippglieds aufgebaut sind, dessen Zustand durch Programmierung eines der Transistoren festgelegt und durch den Zustand eines mit dem Drain-Anschluß (oder dem Source-Anschluß) eines der Transistoren verbundenen Ausgangs angezeigt wird, und an diesem Ausgang das Sperrsignal (INH) oder dessen Inverses abgibt.

10. Verfahren zur Verwendung eines auf die Schaltung nach einem der Ansprüche 1 bis 9 anwendbaren Hauptspeichers, dadurch gekennzeichnet, daß nach der Prüfung des Hauptspeichers vorgesehen ist, die Sperrschaltung (IN) in eine Situation derart zu versetzen, daß diese dann, wenn der Speicher keinerlei Fehler zeigt, die Funktion des Fehleradressenspeichers unterbindet oder wirkungslos macht.

## Claims

1. Redundant memory circuit for a main memory (MP) having several memory areas each accessible by means of a memory address, this redundant circuit comprising a redundant memory addressable by means of a defective address memory of the content addressable type (CAM), intended to contain different defective addresses corresponding to defective areas in the main memory and which, at each addressing of the main memory, compares the main memory address with each defective address in order, in the event of agreement, to inhibit the addressing of the main memory and to address an area of the redundant memory, characterised in that it includes an inhibition circuit (IN) having at least one first state in which it supplies an inhibiting signal (INH) to the defective address memory (CAM) in order to prevent or render ineffective its operation, so that the addressing of the main memory takes place normally when the latter exhibits no defect.

2. Circuit according to Claim 1, characterised in that the inhibition circuit (IN) has a second possible state in which it enables or validates the operation of the defective address memory (CAM).

3. Circuit according to Claim 1, characterised in that the inhibition circuit (IN) is a bistable circuit.

4. Circuit according to Claim 1, characterised in that the defective address memory includes a coincidence circuit (ET) receiving at least one signal of comparison between a main memory address and a defective memory address, the inhibition circuit (IN) inhibiting or validating, according to its state, the operation of the coincidence circuit (ET).

5. Circuit according to Claim 5, characterised in that the coincidence circuit (ET) includes a logic circuit (ET1.1, ET1.m) performing one logic function of the AND type per address and having at least one input per bit of comparison between a defective address information element (ADE1) and a main memory address information element (ADR), and an additional input for a validation signal (VAL) or the inverse of the inhibiting signal.

6. Circuit according to Claim 5, characterised in that it has one coincidence circuit (ET) per defective address (ADR1, ADRn).

7. Circuit according to Claim 1, characterised in that the defective address memory includes at least one circuit having two floating gate transistors (TGF1, TGF2), of the type which constitutes a bistable flip-flop whose state is defined by programming one of the transistors and is indicated by the state of an output connected to the drain (or to the source) of one of the transistors, this output being connected to a comparison circuit (OU-EXCL) also receiving a main memory address information element (ADD1) and supplying a comparison signal; a coincidence circuit (ET) having its inputs connected to several outputs of comparison circuits (OU-EXCL) in order to supply a signal in the event of identity between a main memory address (ADD1) and a defective address, this coincidence circuit also having an additional input for receiving the inverse of the inhibiting signal (INH).

8. Circuit according to Claim 1, characterised in that the inhibition circuit acts on the electrical supply circuit (Vcc) of the defective address memory (CAM) in order to prevent its operation.

9. Circuit according to Claim 3, characterised in that the inhibition circuit includes two floating gate transistors of the type which constitutes a bistable flip-flop whose state is defined by programming one of the transistors as indicated by the state of output connected to the drain (or to the source) of one of the transistors and supplying at this output the inhibiting signal (INH) or its inverse.

10. Method for using a main memory applicable to the circuit according to any one of Claims 1 to 9, characterised in that it makes provision, after the test of the main memory, to put the inhibition circuit (IN) in a situation such that, if the memory exhibits no defect, it inhibits or renders ineffective the operation of the defective address memory.
